# EUROPÄISCHE PATENTSCHRIFT

(11) **EP 1 565 947 B1**
(45) Veröffentlichungstag und Bekanntmachung des Hinweises auf die Patenterteilung: **20.03.2019**
(21) Anmeldenummer: 03767605.3
(22) Anmeldetag: 21.11.2003
(51) Int. Cl.: H01L 51/44, H01L 51/46, H01L 31/0224

(54) **PHOTOVOLTAISCHES BAUELEMENT UND HERSTELLUNGSVERFAHREN DAZU**
PHOTOVOLTAIC COMPONENT AND PRODUCTION METHOD THEREFOR
COMPOSANT PHOTOVOLTAIQUE ET PROCEDE DE PRODUCTION DE CE COMPOSANT

(30) Priorität: 29.11.2002 DE 10255964
(43) Veröffentlichungstag der Anmeldung: 24.08.2005
(73) Patentinhaber: Merck Patent GmbH, 64293 Darmstadt (DE)
(72) Erfinder: BRABEC, Christoph, 91054 Erlangen (DE); WALDAUF, Christoph, 91056 Erlangen (DE)
(86) Internationale Anmeldenummer: PCT/EP2003/013095
(87) Internationale Veröffentlichungsnummer: WO 2004/051756

(56) Entgegenhaltungen:
- EP-A- 1 096 577
- DE-A1- 10 024 993
- US-A- 4 401 545
- US-A- 4 520 086
- US-A- 5 470 505
- US-A- 6 083 635
- US-A1- 2003 099 845
- US-B1- 6 483 099

## Beschreibung

Die Erfindung betrifft ein organisches Bauelement mit verbesserter Topelektrode und ein Herstellungsverfahren dazu.

Bekannt sind zum Beispiel aus der 2002P14485DE photovoltaische Elemente, typischerweise mit folgendem Zellaufbau:
Auf einem Substrat befindet sich eine positive Elektrode (typischerweise ITO, Indium Tin Oxide). Darauf befindet sich gegebenenfalls als Zwischenschicht eine Lochleitschicht, die beispielsweise aus PEDOT mit PSS als Anion besteht. Die angrenzende Schicht ist ein Absorber, also ein photovoltaisch aktives Material, in der Regel ein organischer Halbleiter (z. B. eine Mischung aus konjugiertem Polymer mit Fulleren). Daran schließt die negative Elektrode, die Kathode (z. Bsp: Ca/Ag oder LiF/Al) an. Als Kathodenmaterial kommen bisher unedle Metalle wie Calcium, Barium, Lithiumfluorid, oder ähnliche Werkstoffe mit geringer Austrittsarbeit zum Einsatz. Diese Elektroden werden durch Aufdampfen oder Aufsputtern erzeugt. Die Empfindlichkeit dieser Kathoden-Werkstoffe bedingt jedoch, dass die aus ihnen hergestellten Schichten am besten im Vakuum produziert werden.

Die Verwendung einer vakuumtechnisch aufgebrachten oberen Elektrode (Topelektrode) wie der Kathode, ist aus mehreren Gründen in der Regel unerwünscht, zum einen, weil ein Aufdampf-Prozessschrit im Vakuum kostenintensiv ist, zum anderen weil er produktionstechnisch langsam und wartungsintensiv ist.

Aufgabe der Erfindung ist es daher, ein organisches, photovoltaisches Bauelement zur Verfügung zu stellen, das zumindest ein Substrat mit einer unteren Elektrode, einer Funktionsschicht und einer oberen Elektrode umfasst und das ohne vakuumtechnischen Produktionsschritt herstellbar ist.

Gegenstand der Erfindung ist ein photovoltaisches Bauelement wie in Anspruch 1 definert, mit einer oberen Elektrode aus organischem Material. Außerdem ist Gegenstand der Erfindung ein Verfahren zur Herstellung eines photovoltaischen Bauelements, bei dem auf ein Substrat eine untere Elektrode aufgebracht wird, darauf eine halbleitende photovoltaisch aktive Funktionsschicht und schließlich eine obere organische leitende Funktionsschicht auf die halbleitende photoaktive Funktionsschicht aufgebracht wird, wobei die untere Elektrode semitransparent ist und die obere Elektrode undurchsichtig ist, wie in Anspruch 5 definiert. Als "photovoltaisches Bauelement" wird jedes Bauelement bezeichnet, das eine halbleitende photoaktive Funktionsschicht und eine untere Elektrode aus organischem oder anorganischem Material, eine halbleitende photovoltaisch aktive Funktionsschicht und eine aus überwiegend organischem Material bestehende obere leitende Funktionsschicht (Elektrode) hat.

US 6 483 099 B1 offenbart eine Solarzelle sowie eine invertierte Solarzelle mit einer auf ein Substrat aufgebauten unteren Elektrode, einer halbleitenden photovoltaisch aktiven Schicht, und darauf einer oberen Elektrode aus leitendem organischem Material. Eine Solarzelle gemäß der vorliegenden Erfindung, worin die obere Elektrode undurchsichtig ist, wird darin jedoch nicht offenbart oder nahegelegt.

Wird die obere Elektrode aus semitransparentem Material gebildet, so dass das Substrat keine Transparenz mehr zeigen muss, weil die Photonen durch die semitransparente obere Elektrode auf die halbleitende photovoltaisch aktive Funktionsschicht treffen, kann das kostspielige ITO, das bislang wegen seiner elektrischen Eigenschaften und Transparenz überwiegend als Substrat und/oder untere Elektrode eingesetzt wurde, durch ein billigeres Material wie beispielsweise Al, Ti, Cu oder andere Metallbleche oder Folien ersetzt werden.
In der vorliegenden Erfindung wird ein inverser Aufbau realisiert, das heißt durch den Ersatz der bekannten oberen kathodischen Elektrode aus unedlem Metall durch ein organisches leitendes Material (das in diesem Fall nicht semitransparent ist sondern deckend) tritt eine Vertauschung der Stromrichtung ein, so dass hier, im Falle einer ITO (Indium-Tin-Oxide)-Schicht als untere Elektrode und/oder Substrat die obere Elektrode die positive Elektrode ist und substratseitig die negative Elektrode liegt.

Nach einer Ausführungsform wird das organische photovoltaische Element mit folgenden organischen Materialien realisiert:
Auf ein Substrat aus ITO wird eine halbleitende Schicht, beispielsweise eine P3HT:PCBM (poly(3-hexyllthiophene): ([6,6]-phenyl C₆₁ butyric acid methyl ester)) Mischung (low bandgap) aufgebracht, die die photovoltaisch aktive Funktionsschicht bildet. Darauf kommt eine organische leitende Funktionsschicht, beispielsweise aus PEDOT.

Der Begriff "organisches Material" und/oder "Funktionspolymer" umfasst hier alle Arten von organischen, metallorganischen und/oder anorganischen Kunststoffen, die im Englischen z.B. mit "plastics" bezeichnet werden. Es handelt sich um alle Arten von Stoffen mit Ausnahme der Halbleiter, die die klassischen Dioden bilden (Germanium, Silizium), und der typischen metallischen Leiter. Eine Beschränkung im dogmatischen Sinn auf organisches Material als Kohlenstoff enthaltendes Material ist demnach nicht vorgesehen, vielmehr ist auch an den breiten Einsatz von z.B. Siliconen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich.

Nach einer Ausführungsform des Verfahrens kann das organische elektronische photovoltaisch aktive Element nach folgenden Prozessschritten hergestellt werden:
Zunächst wird ein semitransparentes Substrat, beispielsweise ein ITO-Substrat, mit dem halbleitenden organischen Material beschichtet. Die Beschichtung erfolgt bevorzugt durch massenfertigungstaugliche Techniken wie Bedrucken, spin coating oder ähnliches. Auf die halbleitende Funktionsschicht wird die obere Elektrodenschicht, bevorzugt aus leitendem organischem Material, ebenfalls bevorzugt durch Drucktechnik, aufgebracht.

Nach einer Ausführungsform folgt auf die Herstellung der oberen Elektrodenschicht noch ein Aufdrucken von Ableitungsstegen, beispielsweise aus Silberleitpaste, zur Verringerung von Ohmschen Verlusten. Alternativ dazu können z. Bsp. Carbon Siebdruckpasten eingesetzt werden, aber auch eine Herstellung der Leitpfade mittels kostengünstiger Metallisierung wie Besputtern oder Bedampfen ist vorstellbar.

Als organisches elektronisches photovoltaisch aktives Bauelement wird hier beispielsweise eine Solarzelle, ein Photodetektor, oder jede andere Art elektronischer Bausteine, die als Kernstück eine photovoltaisch aktive Funktionsschicht umfassen, bezeichnet.

Im folgenden wird die Erfindung noch anhand einer beispielhaften Figur, die eine schematische Widergabe eines organischen photovoltaisch aktiven Elements zeigt, näher erläutert.

Auf dem Substrat 1, das beispielsweise aus einer dünnen Folie oder einem dünnen (dünnstem) Glas beschaffen sein kann, wird die untere Elektrode 2, die beispielsweise semitransparent aus ITO beschaffen sein kann, aufgebracht. Auf diese untere Elektrode 2 wird die halbleitende Schicht 3, die photovoltaisch aktiv ist, aus organischem oder auch metallischem oder hybrid-Material gebildet sein kann und bevorzugt eine gute Lösungsmittelprozessierbarkeit hat, aufgebracht. Auf diese Schicht kommt die obere leitende Funktionsschicht oder obere Elektrode 4, die voll absorbierend ausgebildet sein kann.

Eine geeignete photoaktive Schicht (Layer) ist unter anderem aus der US 5,454,880 und der US 5,333,183 bekannt und kann eine oder mehrere halbleitende Kunststoffe, die monomer, oligomer und/oder polymer vorliegen können, sowie anorganische Teilchen und/oder Nanoteilchen umfassen. Es kann eine Mischung aus 2 oder mehreren konjugierten organischen Kunststoffen, anorganischen Teilchen und/oder Nanoteilchen mit ähnlichen oder unterschiedlichen Elektronenaffinitäten und/oder mit ähnlichen oder unterschiedlichen Bandlücken vorliegen.

Dünne Schichten von organischen Molekülen, Oligomeren und molekularen Mischungen können beispielsweise durch thermische Verdampfung, chemical/physical Vapor deposition (CVD) erzeugt werden.

Dünne Schichten von konjugierten Polymeren und Mischungen mit konjugierten Polymeren können durch Spincoaten (Lösungsschleudern), aber auch durch andere gängige Druckmethoden wie z. Bsp. Siebdruck, Tintenstrahldrucken, Flexodruck, Tiefdruck, Hochdruck, Flachdruck (oder andere/ähnliche Lösungsmittelabscheidungsprozesse) erzeugt werden. Wenn Polymere verwendet werden, können diese Schichten auch auf flexible Substrate abgeschieden werden.

Beispiele typischer halbleitender konjugierter Polymere beinhalten Polyacetylene (PA) und Derivate davon, Polyisothianaphtene (PITN) und Derivate davon, Polythiophene (PT) und Derivate davon, Polypyrrole (PPr) und Derivate davon, Poly(2,5-theinylenevinylene) (PTV) und Derivate davon, Polyfluorene (PF) und Derivate davon, Poly(p-phenylene) (PPP) und Derivate davon, Poly(phenylene vinylene) (PPV) und Derivate davon, als auch Polyquinoline und Derivate davon, Polykarbzole und Derivate davon, halbleitendendes Polyanilin (Leukoemeraldine und/oder Leukoemeraldine Base).

Beispiele für Akzeptoren in Donor/Akzeptor Polymermischungen schließen ein, aber sind nicht limitiert auf Poly(cyano-phenylenevinylene), Fullerene wie C60 und dessen funktionelle Derivate (wie PCBM, PCBR) und organische Moleküle, organometallische Moleküle oder inorganische Nanoteilchen (wie z. B. CdTe, CdSe, CdS, CIS).

Des weiteren können verwendete Solarzellen auch in zwei separaten Schichten aufgebaut werden, in denen der Donor vom Akzeptor räumlich getrennt ist (z. Bsp: PT/C60 oder PPV/C60)

Die Erfindung betrifft ein organisches Bauelement verbesserter Topelektrode und ein Herstellungsverfahren dazu. Die Topelektrode ist aus organischem Material, das bevorzugt, aber nicht unbedingt, drucktechnisch aufgebracht wird. Durch das organische Material entsteht die Möglichkeit, bei undurchsichtiger, deckender oberer Elektrode und semitransparenter unterer ITO Elektrode ein photovoltaisches Bauelement mit inversem Aufbau und Stromfluss zu schaffen, weil die obere Elektrode dann die positive Elektrode ist.

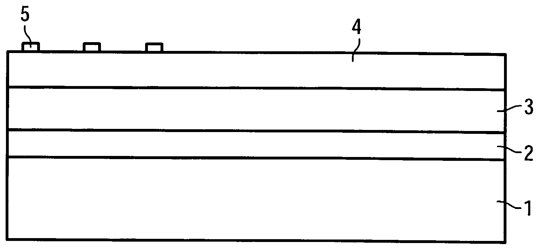

## Patentansprüche

1. Photovoltaisches Bauelement mit
einer auf ein Substrat (1) aufgebrachten unteren Elektrode (2),
einer halbleitenden photovoltaisch aktiven Schicht (3)
**gekennzeichnet durch**
darauf einer oberen Elektrode (4) aus leitendem organischem Material, die die positive Elektrode ist,
bei dem die untere Elektrode (2) semitransparent ist, und die obere Elektrode (4) undurchsichtig ist.

2. Bauelement nach Anspruch 1, bei dem auf der oberen Elektrode (4) noch Ableitungsstege zur Verringerung von Ohmschen Verlusten angeordnet sind.

3. Bauelement nach Anspruch 2, bei dem die Ableitungsstege aus Silberleitpaste sind.

4. Bauelement nach einem der vorhergehenden Ansprüche, **dadurch gekennzeichnet, dass** es eine Solarzelle oder ein Photodetektor ist.

5. Verfahren zur Herstellung eines photovoltaischen Bauelements, bei dem:
- auf ein Substrat (1) eine untere Elektrode aufgebracht wird,
- darauf eine halbleitende photovoltaisch aktive Funktionsschicht (3), **dadurch gekennzeichnet, dass**
- schließlich eine obere Elektrode (4) aus leitendem organischem Material auf die halbleitende photoaktive Funktionsschicht (3) aufgebracht wird, die die positive Elektrode ist,
wobei die untere Elektrode (2) semitransparent ist und die obere Elektrode (4) undurchsichtig ist.

6. Verfahren nach Anspruch 5, bei dem die obere Elektrode (4) drucktechnisch aufgebracht wird.

## Claims

1. Photovoltaic component having
a lower electrode (2) applied to a substrate (1),
a semiconducting photovoltaically active layer (3)
**characterised by**
an upper electrode (4) thereon comprising conductive organic material, which is the positive electrode,
in which the lower electrode (2) is semitransparent, and the upper electrode (4) is opaque.

2. Component according to Claim 1, in which contact strips for reducing ohmic losses are arranged on the upper electrode (4).

3. Component according to Claim 2, in which the contact strips are made from silver conductive paste.

4. Component according to one of the preceding claims, **characterised in that** it is a solar cell or a photodetector.

5. Process for the production of a photovoltaic component, in which:
- a lower electrode is applied to a substrate (1),
- a semiconducting photovoltaically active functional layer (3) is applied thereto,
**characterised in that**
- finally an upper electrode (4) comprising conductive organic material, which is the positive electrode, is applied to the semiconducting photoactive functional layer (3),
where the lower electrode (2) is semitransparent and the upper electrode (4) is opaque.

6. Process according to Claim 5, in which the upper electrode (4) is applied by printing techniques.

## Revendications

1. Composant photovoltaïque comportant :
une électrode inférieure (2) qui est appliquée sur un substrat (1) ;
une couche photovoltaïquement active de semiconduction (3) ;
**caractérisé par** :
une électrode supérieure (4) dessus qui comprend un matériau organique conducteur, laquelle est l'électrode positive ;
dans lequel l'électrode inférieure (2) est semi-transparente et l'électrode supérieure (4) est opaque.

2. Composant selon la revendication 1, dans lequel des bandes de contact pour réduire les pertes ohmiques sont agencées sur l'électrode supérieure (4).

3. Composant selon la revendication 2, dans lequel les bandes de contact sont réalisées à partir d'une pâte conductrice d'argent.

4. Composant selon l'une des revendications qui précèdent, **caractérisé en ce qu'**il s'agit d'une cellule solaire ou d'un photodétecteur.

5. Procédé pour la fabrication d'un composant photovoltaïque, dans lequel :
- une électrode inférieure est appliquée sur un substrat (1) ;
- une couche fonctionnelle photovoltaïquement active de semiconduction (3) est appliquée dessus ;
**caractérisé en ce que** :
- pour finir, une électrode supérieure (4) qui comprend un matériau organique conducteur, laquelle est l'électrode positive, est appliquée sur la couche fonctionnelle photoactive de semiconduction (3) ;
dans lequel l'électrode inférieure (2) est semi-transparente et l'électrode supérieure (4) est opaque.

6. Procédé selon la revendication 5, dans lequel l'électrode supérieure (4) est appliquée au moyen de techniques d'impression.
